Europäisches Patentamt

European Patent Office

Office européen des brevets

(19)

(11) Veröffentlichungsnummer: **0 134 270
B1**

(12) ## EUROPÄISCHE PATENTSCHRIFT

(45) Veröffentlichungstag der Patentschrift:
**03.06.87**

(51) Int. Cl.⁴: **H 03 K 3/288**

(21) Anmeldenummer: **83108130.2**

(22) Anmeldetag: **17.08.83**

(54) **Phasenteiler mit Verriegelung.**

(43) Veröffentlichungstag der Anmeldung:
**20.03.85 Patentblatt 85/12**

(45) Bekanntmachung des Hinweises auf die Patenterteilung:
**03.06.87 Patentblatt 87/23**

(84) Benannte Vertragsstaaten:
**DE FR GB**

(56) Entgegenhaltungen:
GB - A - 1 208 526
US - A - 3 636 377

IBM TECHNICAL DISCLOSURE BULLETIN, Band 15, Nr. 11, April 1973, Seiten 3451-3452, New York, US. B. M. CASSIDY u.a.: "Flip-flop true-complement generator"

(73) Patentinhaber: **IBM DEUTSCHLAND GMBH, Pascalstrasse 100, D-7000 Stuttgart 80 (DE)**
(84) Benannte Vertragsstaaten: **DE**

(73) Patentinhaber: **International Business Machines Corporation, Old Orchard Road, Armonk, N.Y. 10504 (US)**
(84) Benannte Vertragsstaaten: **FR GB**

(72) Erfinder: **Brosch, Rudolf, Dr.-Ing., Seestrasse 104, D-7032 Sindelfingen (DE)**
Erfinder: **Keinert, Joachim, Uhlandstrasse 47, D-7032 Sindelfingen (DE)**
Erfinder: **Klink, Erich, Dipl.-Ing., Max-Eythstrasse 34, D-7036 Schönaich (DE)**
Erfinder: **Wernicke, Friedrich C., Dipl.-Ing., Herdlauchring 6, D-7036 Schönaich (DE)**

(74) Vertreter: **Gaugel, Heinz, Dipl.-Ing. et al, Schönaicher Strasse 220, D-7030 Böblingen (DE)**

EP 0 134 270 B1

**Beschreibung**

Die Erfindung betrifft Phasenteiler mit Verriegelung, enthaltend einen Echt-Komplement-Generator, eine Verriegelungsschaltung und eine Ausgangsstufe.

In ihrer einfachsten Form bestehen Phasenteiler aus einem Inverter, der an seinem Ausgang den invertierten Wert eines zugeführten Eingangssignals liefert, während der nicht invertierte Wert durch eine direkte Verbindung des Eingangs mit einem entsprechenden weiteren Ausgang geliefert wird. Die zahlreichen veröffentlichten und patentierten Abwandlungen dieser Grundform zeigen, dass zur Lösung neu anstehender Probleme verschiedenste Verbesserungen und Verfeinerungen erforderlich sind. So ist die blosse Erzeugung des invertierten oder komplementären und des nicht invertierenden oder echten Ausgangssignals (was gleichbedeutend ist mit der Erzeugung eines gleich- und eines gegenphasigen Signals) aus einem vorgegebenen Eingangssignal häufig nicht allein ausreichend, um die angestrebten qualitativen Eigenschaften des Phasenteilers zu gewährleisten. Die Forderungen nach erhöhter Geschwindigkeit, reduziertem Leistungsverbrauch und exakter zeitlicher Beziehungen zwischen den einzelnen Signalen in der Schaltung machen es häufig notwendig, neue verbesserte Schaltungen und Betriebsarten zu entwickeln. Bei der Herstellung der Schaltungen in integrierter Technologie besteht die zusätzliche Forderung, dass sich die Schaltung mit minimalem Platzaufwand in einem Halbleiterkörper integrieren lässt.

Bistabile Schaltungen, beispielsweise in Form von Flipflops, sind ebenfalls in grosser Anzahl bekannt und finden verbreitete Anwendung. Dazu zählen auch die Verriegelungsschaltungen. Die Wirkungsweise derartiger Schaltungen besteht im Prinzip darin, dass einem Eingang ein Setzsignal zugeführt, aufgrund dessen dann an den Ausgängen ein gleichphasiges und ein gegenphasiges Ausgangssignal erzeugt wird. Diese Ausgangssignale bleiben aufgrund der Rückkopplungs- oder Verriegelungsfunktion bestehen, auch wenn das Setzsignal inzwischen vom Eingang abgeschaltet ist. Die Ausgangssignale, d.h. also der Schaltzustand der Schaltung, bleibt so lange erhalten, bis einem Rückstelleingang ein Rückstellsignal zugeführt wird. Bei bekannten Schaltungen dieser Art gilt grundsätzlich, dass die Ausgangssignale gegenüber dem den Schaltvorgang auslösenden Eingangssignal zeitverzögert sind. Die Grösse dieser Schaltverzögerung ergibt sich aus der Zeitdauer des Verriegelungs- bzw. Umschaltvorganges der Schaltung selbt. In Hochgeschwindigkeitsschaltungen dieser Art sind diese Zeitverzögerungen vielfach unerwünscht oder sogar unzulässig.

So ist aus der deutschen Auslegeschrift 2 422 123 bereits eine bistabile Verriegelungsschaltung bekannt, bei der die Zeitverzögerung des Ausgangssignals gegenüber dem auslösenden Eingangssignal reduziert ist.

Dabei ist ein Eingangs-Ausgangskreis vorgesehen, der aufgrund eines Eingangssignals direkt ein Ausgangssignal liefert. Mit dem Eingangs-Ausgangskreis ist die Verriegelungsschaltung gekoppelt, die aufgrund des Eingangssignals verriegelt und dadurch das Ausgangssignal aufrecht erhält. Nachteilig bei dieser Schaltung ist, dass die Verriegelungsschaltung ständig in Betrieb ist, damit ständig Leistung verbraucht und ausserdem gleichzeitig mit dem Eingangssignal umgeschaltet werden muss. Diese Umschaltung belastet den Eingangs-Ausgangskreis und bewirkt ebenfalls noch eine unerwünschte Zeitverzögerung.

Es sind auch eine ganze Reihe von Anwendungsgebieten für Phasenteiler bekannt, bei denen dieser zusammengesetzt ist aus einem Echt-Komplement-Generator und einer Verriegelungsschaltung. Man strebt mit dieser Kombination das Ziel an, aufgrund eines Eingangssignals möglchst schnell gegenphasige Ausgangssignale zu erhalten und dann eine Verriegelung zu bewirken, so dass der eingestellte Schaltzustand auch bei Abschalten des Eingangssignals oder sogar noch bei nachfolgendem Zuschalten eines zum ersten komplementären zweiten Eingangssignals erhalten bleibt. Hervorzuheben sind Anwendungsgebiete wie verriegelnde Pufferschaltungen und verriegelnde Laserschaltungen für Halbleiterspeicheranordnungen. Pufferschaltungen sind beispielsweise im «IBM Technical Disclosure Bulletin», Vol. 20, Nr. 4, September 1977, Seiten 1426 bis 1429 und im «IBM Technical Disclosure Bulletin», Vol. 18, Nr. 11, April 1976, Seiten 3597 und 3598 veröffentlicht. Diese Schaltungen enthalten neben einem Echt-Komplement-Generator eine Verriegelungsschaltung, in der die vom Echt-Komplement-Generator gelieferten Signale auch nach Ende des auslösenden Eingangssignals des Echt-Komplement-Generators gespeichert bleiben und zur Weiterverwendung bereitgehalten werden.

Nachteilig bei der Schaltung der erstgenannten Veröffentlichung ist, dass das Ausgangssignal erst nach Ablauf des Verriegelungsvorganges zur Verfügung steht und dass eine aufwendige Taktierung der Schaltung erforderlich ist. Auch bei der in der an zweiter Stelle genannten Veröffentlichung gezeigten Schaltung ergeben sich zeitliche Verzögerungen dadurch, dass die Ausgangssignale durch den Verriegelungsvorgang beeinflusst werden, da die Verriegelungsschaltung parallel an die Ausgänge des Echt-Komplement-Generators angeschaltet ist.

Entsprechende Nachteile sind auch den im «IBM Technical Disclosure Bulletin», Vol. 24, Nr. 1B, Juni 1981, Seiten 534 und 535 und in der deutschen Offenlegungsschrift 2 721 851 gezeigten verriegelnden Leseverstärkern zuzuschreiben. Als nachteilig ist hier auch festzustellen, dass die verwendeten Verriegelungsschaltungen in Form von Flipflops ständig aktiv sind, also ständig Strom ziehen und bei einem entsprechenden Schaltvorgang vom einen in den anderen Schaltzustand umzuschalten sind, was zusätzliche Verzögerungen bewirkt. Als wesentliche, gemeinsame Nachteile dieser bekannten Phasenteiler sind herauszustellen ihre Anfälligkeit gegen Temperaturschwankungen, ihr hoher Leistungsverbrauch, ihre Störsignalanfälligkeit und ihre hohe Schaltverzögerung.

Dazu kommt noch, dass digitale Eingangsschaltkreise (z.B. von Halbleiterspeichern) mit Eingangssignalen in der Nähe der positiven Spannungsversorgung häufig nachfolgende Schaltkreise steuern müssen, deren Schaltpegel knapp über der negativen Spannungsversorgung liegt. Dies erfordert interne Pegelkonverter, die die Spannung der Eingangssignale nach Werten in der Nähe der negativen Spannungsversorgung verschiebt. Auch diese Forderung wird von den bekannten Phasenteilern nicht ohne zusätzlichen Aufwand erfüllt.

Schliesslich ist im «IBM Technical Disclosure Bulletin», Vol. 15, Nr. 11, April 1976, S. 3451/3452, ein Phasenteiler mit Verriegelung gemäss dem ersten Teil des Anspruchs 1 beschrieben. Auch bei diesem Phasenteiler sind die Forderungen hinsichtlich Schaltgeschwindigkeit und Leistungsbedarf nicht optimal erfüllt.

Hier will die Erfindung Abhilfe schaffen. Die Erfindung, wie sie in den Ansprüchen gekennzeichnet ist, löst die Aufgabe, einen schnell schaltenden Phasenteiler mit Verriegelung zu schaffen, bei dem die Ausgangsstufen zum Zweck der Leistungseinsparung über einen taktgesteuerten Schalter an die Spannungsversorgung angeschlossen sind, und bei dem mit dem Schliessen dieses Schalters gleichzeitig die Verriegelung der Eingangsinformation und eine angestrebte Pegelverschiebung bewirkt wird.

Der Schaltkreis zeichnet sich durch kurze Schaltzeiten und extreme Unempfindlichkeit gegenüber Spannungs- und Temperaturveränderungen und Prozesstoleranzen aus.

Die Erfindung wird im folgenden anhand von ein Ausführungsbeispiel wiedergebenden Zeichnungen näher erläutert. Es zeigen:

Fig. 1 ein Ausführungsbeispiel des erfindungsgemässen Phasenteilers,

Fig. 2 und 3 Teilschaltbilder, anhand derer die Funktionsweise des erfindungsgemässen Phasenteilers verdeutlicht wird.

Der erfindungsgemässe Phasenteiler umfasst einen als Echt-Komplement-Generator dienenden Stromschalter mit den beiden emittergekoppelten Transistoren T1 und T2. Die Kollektoren dieser Transistoren sind über zugeordnete Widerstände R4 und R5 an einen Pol der Betriebsspannung, im betrachteten Beispiel an den Massepol, geführt. Die beiden gekoppelten Emitter der Transistoren T1 und T2 sind mit einer Stromquelle verbunden, die aus einem Transistor T3 besteht, der über einen Emitterwiderstand R3 an eine Betriebsspannung VEE (–4,25 V) geführt ist. Die Basis des Transistors T3 liegt an einer Spannung VD (–2,75 V). Die Basis des einen emittergekoppelten Widerstandes T2 ist über einen Widerstand R2 mit einer Betriebsspannung VBB (–1,5 V) verbunden. Die Basis des anderen emittergekoppelten Transistors T1 ist über einen Widerstand R1 mit dem Eingang VIN des Echt-Komplement-Generators verbunden. Dabei ist die Basis dieses Transistors zusätzlich über eine Schottky-Diode SD1 mit der Betriebsspannung VBB verbunden. Die Kollektoren der beiden emittergekoppelten Transistoren T1 und T2 sind mit der Basis zweier Transistoren T4 und T5 verbunden, die Emitterfolger bilden und mit ihren Kollektoren an Masse angeschlossen sind. Als Emitterwiderstände dieser beiden Emitterfolger dienen Widerstände R6 und R7, die gleichzeitig Lastelemente zwei die Verriegelungsschaltung bildender, kreuzgekoppelter Transistoren T6 und T7 bilden. Die Kollektorbasisstrecken der beiden kreuzgekoppelten Transistoren T6 und T7 sind jeweils durch eine zugeordnete Schottky-Diode SD6 bzw. SD7 überbrückt. Die Emitterwiderstände R13 und R14 der kreuzgekoppelten Transistoren T6 und T7 sind an die Betriebsspannung VEE (–4,25 V) geführt. Die Emitter der kreuzgekoppelten Transistoren T6 und T7 sind mit jeweils einem der beiden Eingänge einer Ausgangsstufe verbunden, die wiederum aus einem Stromschalter besteht. Dieser Stromschalter umfasst zwei emittergekoppelte Transistoren T8 und T9, deren Kollektoren über Widerstände R8 und R9 mit der Betriebsspannung VBB (–1,5 V) verbunden sind. Im Emitterkreis der beiden Transistoren T8 und T9 ist ein aus einem Transistor T11 bestehender Schalter angeordnet, wobei der Emitter dieses Transistors T11 an die Betriebsspannung VEE und der Kollektor an die verbundenen Emitter der beiden Transistoren T8 und T9 geführt ist. Der aus dem Transistor T11 gebildete Schalter ist über einen Takt CL steuerbar, der über einen Widerstand R15 an die Basis dieses Transistors geführt ist. Die Basisemitterstrecken der beiden Transistoren T8 und T9 sind durch Widerstände R11 und R12 überbrückt. Die Kollektoren der Transistoren T8 und T9 bilden die komplementären Ausgänge OP und IP des erfindungsgemässen Phasenteilers. Dieser Phasenteiler weist aufgrund der an die Basis des Transistors T2 und an die Schottky-Diode SD1 des Echt-Kompllement-Generators angelegten Betriebsspannung VBB von im betrachteten Ausführungsbeispiel –1,5 V einen Schwellwert von –1,5 V auf. Der Phasenteiler liefert an den Ausgängen IP Und OP einen Signalhub von etwa 1,5 V über der Betriebsspannung VEE (–4,25 V). Der als Echt-Komplement-Generator dienende Stromschalter T1, T2 wandelt das einseitige, am Eingang VIN zugeführte Eingangssignal in ein Differenzsignal VA zwischen den Knoten A0 und A1 an den Ausgängen der beiden Emitterfolger T4, T5 um. Dieses Differenzsignal VA kann als internes Eingangssignal angesehen werden, das der gleichzeitig als Verstärker wirkenden Verriegelungsschaltung, bestehend aus den Widerständen R6, R7, den Transistoren T6 und T7 und den Widerständen R13, R14 zugeführt wird. Das interne Differenzsignal VA wird über diese Schaltung in ein verstärktes Differenzsignal VB zwischen den Knoten B0 und B1 an den Emittern der die Verriegelungsschaltung bildenden Transistoren T6 und T7 umgewandelt. Dort wird dieses verstärkte Differenzsignal VB über die Ausgangsstufe mit den Transistoren T8 und T9 abgefühlt, sobald der taktgesteuerte Schalter T11 durch ein Taktsignal CL geschlossen wird und damit die Spannung im Knoten E in Richtung auf die Betriebsspannung VEE absinkt.

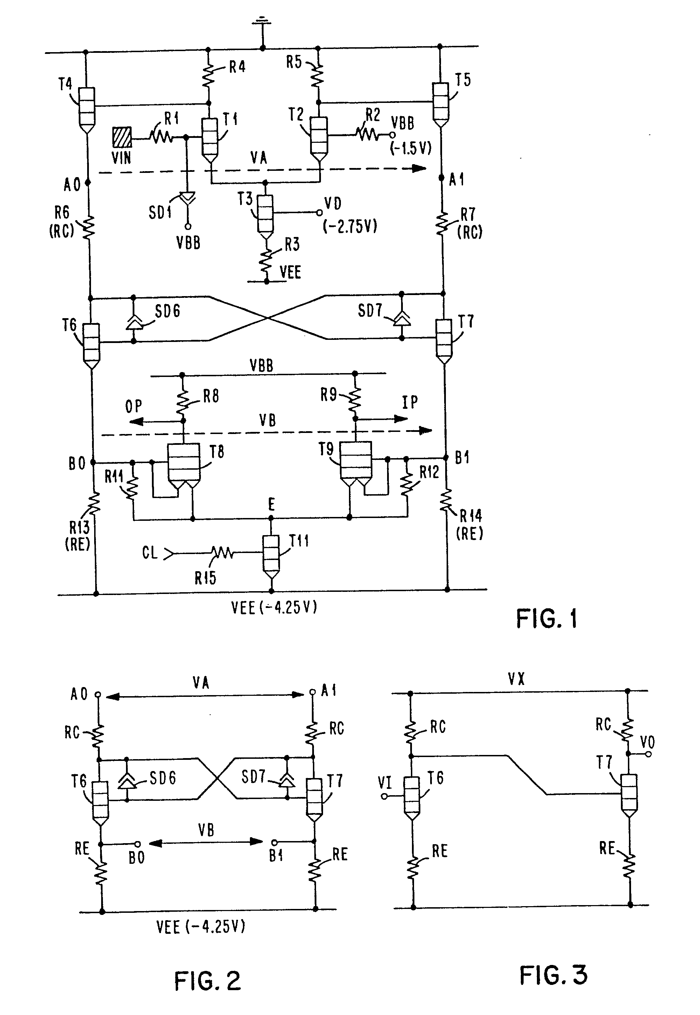

Es seien nun die Wirkungsweise der Schaltung im nicht selektierten Zustand, d.h. bei nicht durchgeschaltetem Schalter T11 näher betrachtet. Zum Zwecke der Klärung der grundsätzlichen Wirkungsweise der Verriegelungs- und Verstärkerschaltung wird zunächst auf die Fig. 2 verwiesen, die die entsprechende Teilschaltung des Phasenteilers gemäss Fig. 1 zeigt. Zur Erleichterung des Verständnisses ist sowohl die Eingangsschaltung als auch die Ausgangsschaltung in Verbindung mit dem taktgesteuerten Schalter T11 nicht berücksichtigt. Im nichtselektierten Zustand ist das Weglassen der Ausgangsstufe ohne Bedeutung, da die Transistoren T8 und T9 infolge des nichtgeschlossenen, taktgesteuerten Schalters T11 stromlos sind. Auch das Weglassen des Echt-Komplement-Generators ist für das Verständnis der Wirkungsweise der Schaltung ohne Bedeutung, da die Abhängigkeit des Differenzsignals VA zwischen den Knoten A0 und A1 vom dem Eingang VIN zugeführten Eingangssignal durch die Stromschaltercharakteristik des Echt-Komplement-Generators definiert ist, die wohlbekannt ist. Es ist also zulässig, das Differenzsignal VA als tatsächliches Eingangssignal der Verriegelungs- und Verstärkerschaltung zu betrachten.

Um im Betrieb das korrekte Ausgangssignal an den Ausgängen OP und IP des Phasenteilers sicherzustellen, muss das Differenzsignal VB zwischen den Knoten B0 und B1 bereits in der richtigen Polarität anliegen, bevor der taktgesteuerte Schalter T11 über den Takt CL in den leitenden Zustand gebracht wird. Das bedeutet, dass das Differenzsignal VB unmittelbar auf jede Änderung des Eingangssignals ansprechen muss, das aufgrund des als Echt-Komplement-Generator verwendeten Stromschalters sofort in Form des internen Differenzsignals VA zwischen den Knoten A0 und A1 ansteht.

Die die Verriegelungsschaltung bildenden Transistoren T6 und T7 sind jeweils zwischen Basis und Kollektor kreuzgekoppelt ähnlich einem konventionellen Flipflop. Es muss verhindert werden, dass das interne Differenzsignal VA bereits im nichtselektierten Zustand des Phasenteilers in der Verriegelungsschaltung verriegelt wird. Wie im folgenden gezeigt wird, kann diese Forderung dadurch erfüllt werden, dass das Verhältnis der Widerstandswerte RC/RE kleiner als 1 ist. Um die Verriegelungsbedingung analysieren zu können, wurde in der Teilschaltung gemäss Fig. 3 die Kopplung zwischen der Basis des Transistors T6 und des Kollektors des Transistors T7 unterbrochen. Die Schaltung bildet somit zwei Inverter, die an dieselbe Stromversorgung VX angeschlossen sind.

Aus den folgenden Gleichungen lässt sich die Verstärkungscharakteristik dieser Schaltung ableiten und die Bedingung aufstellen, bei der die Spannungsverstärkung grösser als 1 wird, was die notwendige Voraussetzung ist für das Verriegeln der Verriegelungsschaltung.

$$VI = VBE6 + I6 * RE$$

$$VO = VX - I7 * RC$$

$$I7 = \frac{VX - I6 * RC - VBE7}{RE}$$

$$\frac{VO}{VI} = \left(\frac{RC}{RE}\right)^2 \qquad (1)$$

Dabei stellen dar: VI die Eingangsspannung, VO die Ausgangsspannung, VX die Betriebsspannung, VBE6 und VBE7 die Basis-Emitterspannungen der Transistoren T6 und T7, I6 und I7 den Emitterstrom

bzw. den Kollektorstrom des Transistors T6 bzw. T7 und RE und RC die Grösse der Emitter- bzw. Kollektorwiderstände, wobei RE den Wert der Widerstände R13 und R14 und RC den Wert der Widerstände R6 und R7 den der vollständigen Schaltung des Phasenteilers nach Fig. 1 darstellen.

Aus Gleichung (1) ist abzulesen, dass die Verstärkung nur abhängig ist vom Verhältnis RC/RE. Solange der Widerstandswert RC kleiner ist als der Widerstandswert RE ist die Verstärkung kleiner als 1 und eine Verriegelung des Eingangssignals wird in jedem Falle verhindert. Das bedeutet, dass sich eine Veränderung des internen Differenzsignals VA unmittelbar in einer Änderung des Differenzsignals VB niederschlägt.

Einen weiteren Einblick in die Funktion der Schaltung erhält man aus der Berechnung der Verstärkung G = VB/VA. Dabei sind folgende Gleichungen in Verbindung mit der Teilschaltung nach Fig. 2 heranzuziehen:

$$VA = RC*I7 + VBE6 + RE*I6 - RE*I7 - VBE7 - RC*I6$$

$$VB = RE*I6 - RE \cdot I7$$

$$VBE6 \approx VBE7$$

Die Gesamtverstärkung ist:

$$G = \frac{VB}{VA} = \frac{RE \, (I6 - I7)}{RC \, (I6 - I7) + RE \, (I6 - I7)}$$

$$= \frac{RE}{RE - RC}$$

$$= \frac{1}{1 - \frac{RC}{RE}} \qquad (2)$$

Die Gleichung (2) zeigt die positive Rückkopplung. Abhängig vom Wert RC/RE sind drei Fälle positiver Rückkopplung möglich.

Ist RC/RE < 1, so ergibt sich aus der Gleichung (2) eine endliche Verstärkung, die nur vom Wert des Widerstandsverhältnisses abhängt.

Nähert sich das Widerstandsverhältnis RC/RE dem Wert 1, so strebt die Verstärkung gegen unendlich. Selbstverständlich ist eine unendliche Verstärkung in der praktischen Ausführung von Schaltungen infolge der begrenzten Grösse der aktiven Zonen der Transistoren nicht möglich. Das kleinste Eingangssignal führt jedoch dazu, dass das verstärkende Element aus dem aktiven Bereich in den Sättigungsbereich getrieben wird. In diesem Falle wird eine der Dioden SD6, SD7 in der Schaltung nach Fig. 1 leitend und begrenzt damit das Differenzsignal VB auf etwa 500 mV.

Ein Anheben des Widerstandsverhältnisses RC/RE über 1 bewirkt das Verriegeln der kreuzgekoppelten Transistoren T6 und T7. Unter Voraussetzung, dass dem verriegelnden Transistor ausreichend Basisstrom zugeführt wird, kann das Eingangssignal nach dem Verriegeln das Differenzsignal VB nicht mehr ändern.

Wie bereits herausgestellt, muss im nichtselektierten Zustand des Phasenteilers das Differenzsignal VB unmittelbar auf Änderungen des Differenzsignals VA ansprechen. Aus diesem Grunde wurde in einem praktischen Ausführungsbeispiel ein Verhältnis RC/RE von 1,1/4 < 1 gewählt, was eine Verstärkung von 1,4 ergibt. Dabei tritt keine Verriegelung ein. Um eine Schwingneigung aufgrund der positiven Rückkopplung zu vermeiden, sollte das Differenzsignal Va gross genug sein, um die Begrenzerdiode SD6 bzw. SD7 des verriegelnden Transistors in den leitenden Zustand zu bringen. Nimmt man eine Spannung von 500 mV ( = VB) an der leitenden Schottky-Diode SD6 bzw. SD7 an, so erhält man für das niedrigste Differenzsignal VA, bei dem im betrachteten Ausführungsbeispiel ein stabiler Betrieb noch möglich ist, einen Wert von VA > VB/1,4 = 360 mV.

Im folgenden sei nun der Phasenteiler im selektierten Zustand, d.h., mit geschlossenem, taktgesteuerten Schalter T11, näher betrachtet.

Eine der Grundforderungen an den erfindungsgemässen Phasenteiler besteht in einem niedrigen Leistungsverbrauch, insbesondere im nichtselektierten Ruhezustand. Zu diesem Zweck sind die Emitter der Transistore T8 und T9 der Ausgangsstufe mit dem Kollektor des Transistors T11 verbunden, der bei Zufuhr eines Taktimpulses CL in den leitenden Zustand geschaltet wird und dabei die genannten Emitter mit der negativsten Betriebsspannung VEE verbindet.

Sobald dieser Schalter T11 geschlossen ist, zeigt die Ausgangsstufe das bekannte Verhalten eines Stromschalters aus den Transistoren T8 und T9, deren Basen das Differenzsignal VB zugeführt wird. Unter der Voraussetzung, dass das interne Differenzsignal VA hoch genug ist, ist entweder die Schottky-Diode SD6 oder die Schottky-Diode SD7 leitend, so dass im betrachteten Beispiel ein maximales Differenzsignal VB von etwa 500 mV erzeugt wird. Wie bereits erwähnt, reicht dazu ein Differenzsignal VA > 350 mV aus. Es ist darauf hinzuweisen, dass die tatsächliche Spannung an den Knoten B0 und B1 von geringem Interesse ist. Lediglich die Potentialdifferenz VB, die zwischen den Basen der Transistoren T8 und T9 anliegt, ist von Bedeutung. Selbstverständlich hängt die Polarität des Differenzsignals VB vom logischen Zustand des am Eingang VIN zugeführten Eingangssignals ab, das bereits vor Durchschalten des taktgesteuerten Schalters T11 anliegen muss. Solange dieser Schalter gesperrt ist, sind die Transistoren T8 und T9 nichtleitend, die komplementären Ausgänge IP und OP befinden sich in einem oberen Pegelwert, und das Potential am gemeinsamen Emitterknoten E der Transistoren T8 und T9 liegt auf einem mittleren Wert zwischen den Pegeln an den Knoten B0 und B1.

Es sei nun beispielsweise angenommen, das Potential an der Basis des Transistors T8 sei hoch im Vergleich zum Potential an der Basis des Transistors T9. Sobald eine Selektion stattfinden soll, erscheint das Taktsignal CL und schaltet den Phasenteiler in der beschriebenen Weise ein. Sobald das Potential am Knoten E über den Kollektorstrom des Transistors T11 abgesenkt ist, steigt die Spannung an der Basis-Emitterstrecke des Transistors T8 an, bis Transistor T8 leitet und dabei das Potential am Ausgang OP absinkt. Gleichzeitig wird das Potential am Emitter des Transistors T6 auf einem Potential festgehalten, das eine Basis-Emitterspannung VBE über dem Potential des Knotens E liegt.

Die Spannung am Kollektor des Transistors T6 wird etwa um denselben Betrag abgesenkt, so dass das Potential an der Basis des Transistors T9 immer noch etwa 500 mV unterhalb des Potentials an der Basis des Transistors T8 bleibt und damit verhindert, dass der Transistor T9 leitend wird.

Mit Hilfe der Gleichungen (1) und (2) lässt sich das charakteristische Merkmal der Verriegelungs- und Verstärkerschaltung nach Durchschalten des Schalters T11 leicht über den Widerstandswert RE analysieren. Die leitende Basis-Emitterstrecke eines der Transistoren T8 und T9 der Ausgangsstufe bildet einen niederohmigen Parallelpfad zu dem zugeordneten Emitterwiderstand R13 oder R14, so dass dessen Widerstandswert RE durch einen neuen kleineren Widerstandswert re ersetzt wird.

Angenommen, der Widerstandswert re beträgt nur etwa wenige Ohm, so ist das Verhältnis RC/re sicherlich viel grösser als 1. Unter dieser Voraussetzung aber folgt die Verriegelung der Verriegelungsschaltung aus den Transistoren T6 und T7 wie bereits beschrieben. Mit der Verriegelung des aus dem Eingangssignal gebildeten komplementären Ausgangssignals erfolgt gleichzeitig eine Pegelverschiebung, bei der der hohe Pegel des Eingangssignals in einen Pegel des Ausgangssignals von lediglich 200 mV über der negativsten Betriebsspannung VEE umgewandelt wird. Der erfindungsgemässe Phasenteiler zeigt hervorragende Eigenschaften in bezug auf Leistungsverbrauch und Temperaturänderungen und ist ausserordentlich unempfindlich gegen Störsignale und Prozesstoleranzen. Das Widerstandsverhältnis RC/RE, das die Funktion der Schaltung bestimmt, kann leicht auf einem ausgewählten Wert gehalten werden. Dieser Wert ist weder abhängig von Spannungs- noch Temperaturänderungen und wird kaum von Prozesstoleranzen beeinflusst.

Die maximale Betriebsspannung, bei der die Schaltung arbeitet, ist theoretisch unbegrenzt. Die minimale Betriebsspannung hängt vom Widerstandswert RC ab, der ausreichend Basisstrom für den jeweiligen Transistor der Ausgangsstufe liefern muss. Unter Annahme gebräuchlicher Widerstandswerte kann man eine minimale Betriebsspannung von mindestens 3 V annehmen, bei der das schnelle Schaltverhalten erhalten bleibt. Da die verschiedenen Funktionen wie Pegelverschiebung, Aktivierung der Transistoren der Ausgangsstufe und Verriegelung des Eingangssignals gleichzeitig erfolgen, ist die Verzögerung vom Eingang zum Ausgang des Phasenteilers extrem kurz. Der Leistungsverbrauch, der von der Grösse der Stromquelle T3, R3 des Echt-Komplement-Generators und dem Widerstandswert RE bestimmt wird, kann gering gehalten werden, da die Funktion der Schaltung auf kleinen Differenzsignalen basiert und nicht auf absoluten Spannungshüben, die gross sein müssen, wenn Betriebsspannungsschwankungen und Temperaturschwankungen bei üblichen Phasenteilern kompensiert werden sollen.

## Patentansprüche

1. Phasenteiler mit Verriegelung, enthaltend einen Echt-Komplement-Generator, eine Verriegelungsschaltung und eine Ausgangsstufe, wobei die beiden Ausgänge des Echt-Komplement-Generators, an dessen Eingang (VIN) das Eingangssignal angelegt wird, jeweils mit dem Eingang eines zugeordneten Emitterfolgers (T4, T5) verbunden sind und die beiden Emitterfolger (T4, T5) gleiche Emitterwiderstände (R6, R7) aufweisen, die gleichzeitig als Kollektor-Lastwiderstände zweier kreuzgekoppelter, die Verriegelungs- und Verstärkerschaltung bildender Transistoren (T6, T7) dienen, dadurch gekennzeichnet, dass die beiden kreuzgekoppelten Transistoren (T6, T7) ebenfalls gleiche aber höhere Emitterwiderstände (R13, R14) als die Emitterfolger (T4, T5) aufweisen, dass die Emitter der kreuzgekoppelten Transistoren (T6, T7) mit jeweils einem der beiden Eingänge (B0, B1) der Ausgangsstufe (T8, T9, T11) verbunden sind, die über einen taktgesteuerten Schalter (T11) an Betriebsspannung (VEE) anlegbar sind und dabei den wirksamen Emitterwiderstand eines der kreuzgekoppelten Transistoren (T6, T7) unter den Wert der Emitterwiderstände (R6, R7) der Emitterfolger (T4, T5) verkleinert und dadurch in Abhängigkeit vom Eingangssignal die Verriegelung der Verriegelungsschaltung bewirkt.

2. Phasenteiler nach Anspruch 1, dadurch gekennzeichnet, dass der Echt-Komplement-Generator einen emittergekoppelten Stromschalter mit zwei Transistoren (T1, T2) umfasst, in deren Emitterkreis eine gemeinsame Stromquelle (T3, R3) angeordnet ist.

3. Phasenteiler nach Anspruch 1, dadurch gekennzeichnet, dass die Ausgangsstufe einen emittergekoppelten Stromschalter mit zwei Transistoren (T8, T9) umfasst, in deren Emitterkreis der taktgesteuerte Schalter (T11) angeordnet ist, der im stromführenden Zustand die Basis-Emitterstrecke des jeweils leitenden Zweiges parallel zum Emitterwiderstand der kreuzgekoppelten Transistoren (T6, T7) schaltet und den wirksamen Emitterwiderstand verringert.

## Claims

1. Latched phase splitter, comprising a true complement generator, a latch circuit and an output stage, wherein the two oputputs of the true complement generator, to the input (VIN) of which the input signal is applied, are each connected to the input of an associated emitter-follower (T4, T5), and the two emitter-followers (T4, T5) have identical emitter resistors (R6, R7) which simultaneously act as collector load resistors of two cross-coupled transistors (T6, T7) forming the latch and amplifier circuit, characterized in that the two cross-coupled transistors (T6, T7) also comprise identical but higher emitter resistors (R13, R14) than the emitter-followers (T4, T5), that the emitters of the cross-coupled transistors (T6, T7) are each connected to one of the two inputs (B0, B1) of the oputput stage (T8, T9, T11) which through a clock-controlled switch (T11) is connected to operating voltage (VEE), reducing the active emitter resistance of one of the cross-coupled transistors (T6, T7) below the value of the emitter resistors (R6, R7) of the emitter-followers (T4, T5), thus causing the latch circuit to be latched as a function of the input signal.

2. Phase splitter according to claim 1, characterized in that the true comlement generator comprises an emitter-coupled current switch with two transistors (T1, T2), in the emitter circuit of which a common current source (T3, R3) is arranged.

3. Phase splitter according to claim 1, characterized in that the oputput stage comprises an emitter-coupled current switch with two transistors (T8, T9), in the emitter circuit of which the clock-controlled switch (T11) is arranged which in the conductive state switches the base-emitter junction of the respective conductive branch parallel to the emitter resistor of the cross-coupled transistors (T6, T7), reducing the active emitter resistance.

## Revendications

1. Diviseur de phase à verrouillage, contenant un générateur de signal réel (non inversé) et de signal complémentaire (inversé), un circuit de verrouillage et un étage de sortie, et dans lequel les deux sorties du générateur de signal réel et de signal complémentaire, à l'entrée (VIN) duquel est appliqué le signal d'entrée, sont raccordées respectivement à l'entrée d'émetteurs-suiveurs associés (T4, T5) et les deux émetteurs-suiveurs (T4, T5) possèdent des résistances d'émetteur identiques (R6, R7), qui servent simultanément de résistances de charge de collecteur de deux transistors (T6, T7) couplés selon un couplage croisé et constituant le circuit de verrouillage et d'amplification, caractérisé par le fait que les deux transistors (T6, T7) couplés selon un couplage croisé possèdent également des résistances d'émetteur (R13, R14) identiques, mais d'une valeur plus élevée que les émetteurs-suiveurs (T4, T5), que les émetteurs de transistors (T6, T7) couplés selon un couplage croisé sont reliés respectivement à l'une des deux entrées (B0, B1) de l'étage de sortie (T8, T9, T11), qui peut être placé à la tension de service (VEE) par l'intermédiaire d'un interrupteur (T11) commandé de façon cadencée et ainsi abaisse la résistance effective d'émetteur de l'un des transistors (T6, T7) couplé selon un couplage croisé, au-dessous de la valeur des résistances d'émetteur (R6, R7) des émetteurs-suiveurs (T4, T5) et réalise de ce fait, en fonction du signal d'entrée, le verrouillage du circuit de verrouillage.

2. Diviseur de phase selon la revendication 1, caractérisé en ce que le générateur de signal réel et de signal complémentaire comporte un interrupteur de courant à émetteurs couplés, comprenant deux transistors (T1, T2), dans le circuit des émetteurs desquels se trouve disposée une source commune de courant (T3, R3).

3. Diviseur de phase selon la revendication 1, caractérisé en ce que l'étage de sortie comporte un interrupteur de courant à émetteurs couplés, comprenant deux transistors (T8, T9), dans le circuit des émetteurs desquels se trouve disposé l'interrupteur (T11) commandé de façon cadencée, qui, dans l'état où il conduit le courant, branche la voie base-émetteur de la branche respectivement conductrice en parallèle avec les résistances d'émetteurs des transistors (T6, T7) couplés selon un couplage croisé et réduit la résistance effective d'émetteur.

FIG. 1

FIG. 2

FIG. 3